(19) Europäisches Patentamt
European Patent Office
Office européen des brevets

(11) Publication number: **0 542 218 A1**

(12) **EUROPEAN PATENT APPLICATION**

(21) Application number: **92119268.8**

(22) Date of filing: **11.11.92**

(51) Int. Cl.[5]: **C08G 59/62**, C08G 59/24, C09D 163/00

(30) Priority: **12.11.91 US 790873**

(43) Date of publication of application: **19.05.93 Bulletin 93/20**

(84) Designated Contracting States: **AT BE DE DK ES FR GB IT NL SE**

(71) Applicant: **UNION CARBIDE CHEMICALS & PLASTICS TECHNOLOGY CORPORATION**
**39 Old Ridgebury Road**
**Danbury, Connecticut 06817-0001(US)**

(72) Inventor: **Argyropoulos, John Nicholas**
**35 Michael Street**
**Scott Depot, West Virginia 25560(US)**
Inventor: **Smith, Oliver Wendell**
**850 Walters Road**
**Charleston, West Virginia 25314(US)**
Inventor: **Bassett, David Robinson**
**2018 Huber Road**
**Charleston, West Virginia 25314(US)**
Inventor: **Koleske, Joseph Victor**
**1513 Brentwood Road**
**Charleston, West Virginia 25314(US)**

(74) Representative: **Brandes, Jürgen, Dr. et al**
**Wuesthoff & Wuesthoff Patent- und Rechtsanwälte Schweigerstrasse 2**
**W-8000 München 90 (DE)**

(54) **Conformal coating compositions.**

(57) This invention relates to curable conformal coating compositions prepared from certain liquid hydrocarbon diols and/or derivatives of said liquid hydrocarbon diols, cycloaliphatic epoxides, and optionally other epoxides, polyols, vinyl esters, onium salt photoinitiators and other ingredients. The conformal coating compositions are curable with actinic or thermal energy and are useful as protective coatings for electrical and electronic devices.

EP 0 542 218 A1

## Brief Summary of the Invention

### Technical field

This invention relates to curable conformal coating compositions prepared from certain liquid hydrocarbon diols and/or derivatives of said liquid hydrocarbon diols, cycloaliphatic epoxides, and optionally other epoxides, polyols, vinyl esters, onium salt photoinitiators and other ingredients. The conformal coating compositions are curable with actinic or thermal energy and are useful as protective coatings for electrical and electronic devices.

## Background of the Invention

Conformal coatings are coatings that encapsulate a printed circuit board or wired circuit board and their components. This complete envelope of encapsulating material provides protection from humidity, moisture, dust, fungus, grease, salt, liquid water and aqueous solutions, and other contaminants that could deleteriously alter the operation of an electrical device. In addition, properly applied conformal coatings enhance electrical circuit reliability by elimination of current or voltage leakage from high impedance circuits. Conformal coatings are also used to protect a portion of a printed circuit board, as for example the bottom of a board which can contain a host of solder points, or to protect even a particular component, as for example one that might be subject to an electrical arc in a voltage discharge situation. Various types of materials that are used for conformal coatings are described by Tautscher, C.J., Protective Circuit Coatings, Novatech Research Corp., Redmond, WA (1981), which is incorporated herein by reference. In addition, J. Waryold of HumiSeal has published a paper "How to Select a Conformal Coating for Printed Circuit Boards", Insulation/Circuits, July 1974, that describes conformal coatings.

Most conventional conformal coatings comprise solutions of thermoplastic polymers or are mixtures of reactive components in a solvent. After the solution coating is applied to a printed circuit board substrate, the solvent is removed by long time evaporation at room temperature or at a moderately elevated temperature. Elevated temperatures can only be moderate, usually less than about 110 ° C, because of bubbling of the evaporating solvent and of the temperature sensitive components such as capacitors that are present on the circuit board. When reactive components are involved, the applied liquid system is a mixture of two or more components or packages, and the blended materials have a relatively short pot live on the order of a few hours or less to about 24 hours. More recently, there has been technology developed that involves the photocuring of conformal coating formulations that contain photoinitiators that photolyze when exposed to ultraviolet radiation. This technology markedly decreases the time required to cure reactive coatings and improves quality factors. However, even though such ultraviolet light-curable coatings are important advances, they have need of improvement to make them even more utile in application and in protecting electrical/electronic circuitry. Improvements in the irritation and other sensitivity factors are needed for some coatings, improvements in odor of others is needed. Lower viscosity systems are desirable and will eliminate or decrease the need for added inert solvent that can add to cost and adversely affect the environment. One area that needs improvement is that of moisture and water resistance as would be found under conditions of high humidity, condensing moisture, and even liquid water contact as might be encountered in rain, snow, or melting snow.

U.S. Patent 5,043,221 discloses printed circuit boards that have been coated with a conformal coating consisting essentially of a cycloaliphatic epoxide, a poly(tetramethylene oxide) polyol, and a photoinitiator. The conformally coated product is moisture resistant and has an electrical insulation resistance of greater than about 2.5 x $10^{12}$ ohms.

U.S. Patent 4,256,828 discloses information about photocurable compositions that contain cycloaliphatic epoxides, organic compounds that have hydroxyl functionality, and photosensitive aromatic sulfonium or iodonium salts. U.S. Patent 4,216,288, U.S. Patent 4,193,799, and U.S. Patent 4,108,747 deal with photocurable compositions that can be used as photoresists.

## Disclosure of the Invention

This invention relates to conformal coating compositions containing certain liquid hydrocarbon diols and/or derivatives of said liquid hydrocarbon diols that have improved moisture resistance and are curable by actinic radiation and/or thermal energy, to circuitry that has coated thereon said coating compositions, and to cured films prepared from said coating compositions on various substrates such as printed circuit boards, associated metal, plastics, electrical components, and the like. More particularly, this invention

relates to curable coating compositions comprising liquid hydrocarbon diols and/or derivative products based on the liquid hydrocarbon diols, cycloaliphatic epoxides, and optionally other epoxides, polyols, vinyl esters and onium salt photoinitiators when curing is effected by ultraviolet light alone or in combination with thermal energy or triflic acid salts or other blocked Bronsted acids when curing is effected by thermal means.

The liquid hydrocarbon diols used in the coating compositions of this invention are comprised of primary hydroxyl groups and 8 or more carbon atoms in which the primary hydroxyl groups are separated by 4 or more carbon atoms linearly arranged and in which at least one of said carbon atoms linearly arranged is a disubstituted carbon atom or at least 2 of said carbon atoms linearly arranged are monosubstituted carbon atoms, said liquid hydrocarbon diol existing as a liquid at a temperature of 35 °C or less.

The curable coating compositions are stable and are used for coating various metal, ceramic, glass, plastic and composite substrates which can be in the form of a printed circuit board, a wired circuit board, or printed circuit board with a variety of components and often called a printed circuit assembly; of electrical components; semiconductor chips with or without information and functional circuitry and similar devices used in the electrical/electronics industry.

Detailed Description

This invention relates to high solids curable conformal coating compositions, cured conformal coating compositions, and electrical/electronic circuitry that has the conformal coating compositions cured thereon wherein said conformal coatings are polymer compositions containing certain liquid hydrocarbon diols and/or derivative products based on the liquid hydrocarbon diols, cycloaliphatic epoxides; optionally other epoxides, polyols, vinyl esters, surfactants, flow and leveling agents; and onium salt photoinitiators when curing is effected by means of ultraviolet light or a combination of ultraviolet light and thermal energy or triflic acid salts and other blocked Bronsted acids when curing is effected by thermal means. Properties are developed rapidly, and the liquid coatings are cured to a tack-free state after passage of a few seconds or even less. Although it is not necessary to apply thermal energy after the application of actinic radiation to complete cure, it may be advantageous to heat the exposed coating after exposure to the actinic radiation source.

This invention relates to conformal coating compositions that when cured by actinic radiation, particularly ultraviolet radiation, and/or thermal energy have desirable moisture resistance and odor characteristics; have good electrical resistance and dielectric properties, including dielectric breakdown voltage; and are not particularly irritating or sensitizing to living beings. The coating compositions of this invention can be applied as conformal coatings to printed circuit boards, printed circuit assemblies, to portions of printed circuit boards or assemblies, or to particular components on or to be used on printed circuit boards, and they can be cured thereon with ultraviolet light alone, a combination of ultraviolet light and thermal energy, or thermal energy alone. This invention provides printed circuitry that has the curable coating compositions of this invention cured thereon.

The liquid hydrocarbon diols used in the conformal coating compositions of this invention are those comprised of primary hydroxyl groups and 8 or more carbon atoms in which the primary hydroxyl groups are separated by 4 or more carbon atoms linearly arranged and in which at least one of said carbon atoms linearly arranged is a disubstituted carbon atom or at least 2 of said carbon atoms linearly arranged are monosubstituted carbon atoms, said liquid hydrocarbon diols existing as a liquid at temperatures of 35 °C or less.

The preferred liquid hydrocarbon diols for use in this invention can be represented by the formula:

$$HO - R'' - OH \qquad (I)$$

wherein R'' is a substituted hydrocarbon residue having 8 or more carbon atoms in which the primary hydroxyl groups are separated by 4 or more carbon atoms linearly arranged and in which at least one of said carbon atoms linearly arranged is a disubstituted carbon atom or at least 2 of said carbon atoms linearly arranged are monosubstituted carbon atoms, said liquid hydrocarbon diols existing as a liquid at a temperature of 35 °C or less.

Other preferred liquid hydrocarbon diols for use as a neat form component or in the derivative products based on said liquid hydrocarbon diols in the conformal coating compositions of the invention are the substituted 1,5-pentanediols of Formula II:

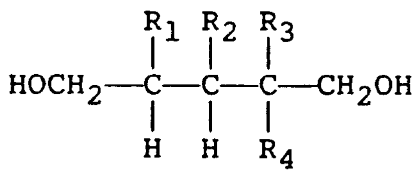

(II)

wherein $R_1$ is hydrogen or linear or branched alkyl having 1 to 3 carbon atoms, and $R_2$, $R_3$, and $R_4$ are the same or different and are hydrogen or linear or branched alkyl having 1 to 4 carbon atoms, said liquid hydrocarbon diol existing as a liquid at a temperature of 35 °C or less; provided (a) at least 2 of $R_1$, $R_2$, $R_3$, and $R_4$ are other than hydrogen; (b) the total number of carbon atoms in $R_1$ $R_2$, $R_3$, and $R_4$ together is 5 or more except as follows: (i) when $R_2$ is ethyl and one of $R_1$, $R_3$, and $R_4$ is methyl, then the remaining 2 of $R_1$, $R_3$, and $R_4$ can be hydrogen; (ii) when $R_3$ and $R_4$ are independently methyl and propyl, then $R_1$ and $R_2$ can be hydrogen; and (iii) when $R_1$ is methyl and $R_2$ is ethyl and one of $R_3$ and $R_4$ is methyl, then the remaining $R_3$ or $R_4$ can be hydrogen; (c) when the total number of carbon atoms in $R_1$ and $R_2$ is 4 or more, then the total number of carbon atoms in $R_2$ is 3 or less except when $R_1$ is propyl and $R_3$ and $R_4$ are hydrogen, then $R_2$ can be butyl; and (d) when $R_1$ is ethyl and $R_2$ is propyl, then $R_3$ is other than ethyl. It is preferred that one of $R_3$ or $R_4$ be hydrogen and that the total number of carbon atoms contained in $R_1$ to $R_4$ is 3 to 7, and it is most preferred that $R_3$ and $R_4$ be hydrogen and $R_1$ and $R_2$ contain a total of 4 to 6 carbon atoms. For example, if $R_1$ is $CH_3CH_2-$, $R_2$ is $CH_3CH_2CH_2-$, and $R_3$ and $R_4$ are hydrogen, there would be a total of 5 carbon atoms contained in $R_1$ to $R_4$; and if $R_1$ is ethyl, $R_2$ is butyl, $R_3$ is propyl, and $R_4$ is ethyl, there would be a total of 11 carbon atoms contained in $R_1$ to $R_4$.

The liquid hydrocarbon diols useful in this invention, for example, the liquid 1,5-pentanediols represented by Formula II above, can be prepared by a process comprising:

(a) contacting a substituted vinyl ether with a substituted or unsubstituted acrolein to form a substituted 3,4-dihydropyran;

(b) contacting the substituted 3,4-dihydropyran with an acid catalyst to form a substituted dialdehyde; and

(c) hydrogenating the substituted dialdehyde in the presence of a catalyst to form a liquid hydrocarbon diol represented by Formula II above.

More particularly, the liquid substituted 1,5-pentanediols represented by Formula II above can be prepared by reacting acrolein or substituted acrolein with a substituted vinyl ether as follows:

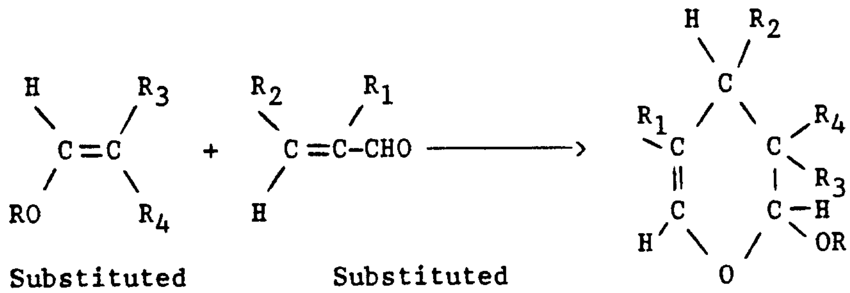

Substituted Vinyl Ether

Substituted Acrolein

Substituted 3,4-Dihydropyran

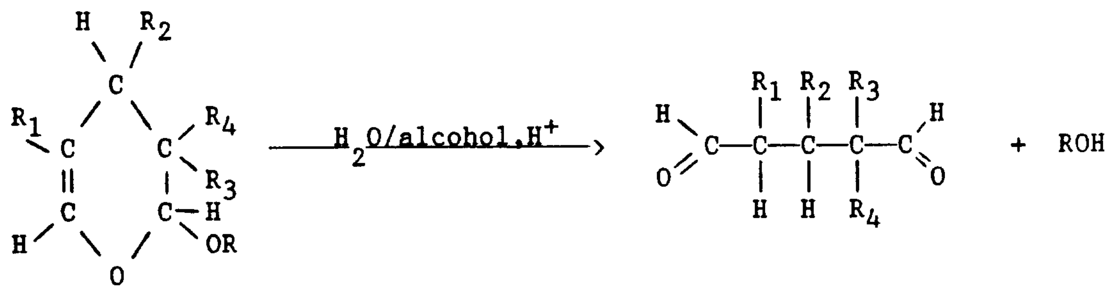


Substituted 3,4-Dihydropyran

Substituted Dialdehyde

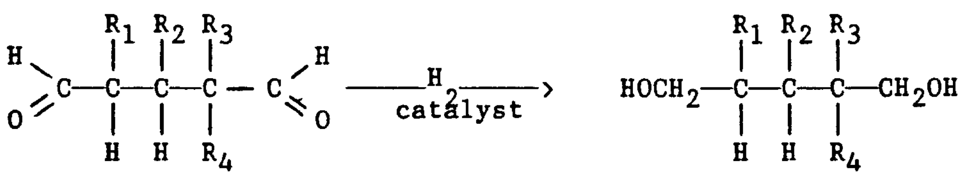


Substituted Dialdehyde

Substituted 1,5-Pentanediol

wherein $R_1$, $R_2$, $R_3$ and $R_4$ are as defined above and R is a substituted or unsubstituted hydrocarbon residue, preferably a linear or branched alkyl having from 1 to about 8 carbon atoms.

Illustrative of suitable substituted vinyl ethers useful in preparing the liquid hydrocarbon diols include, among others, alkyl vinyl ethers such as methyl vinyl ether; methyl (2-methyl vinyl) ether which has the structure:

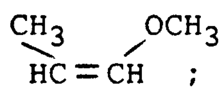 ;

methyl (2-ethyl vinyl) ether, which has the structure:

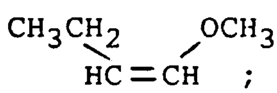 ;

methyl (2,2 – dimethyl vinyl) ether; methyl (2 – methyl, 2 – propyl vinyl) ether; methyl (2 – butyl, 2 – methyl vinyl) ether; ethyl vinyl ether; ethyl (2 – methyl vinyl); ethyl (2 – ethyl vinyl) ether; ethyl (2,2 – dimethyl vinyl) ether; ethyl (2 – methyl, 2 – propyl vinyl) ether; ethyl (2 – butyl, 2 – methyl vinyl) ether; n – propyl and i – propyl vinyl ethers; butyl vinyl ethers such as n – butyl vinyl ether, s – butyl vinyl ether, i – butyl vinyl ether, and t – butyl vinyl ether; amyl vinyl ethers, and the like; divinyl ethers such as triethylene glycol divinyl ether, 1,4 – cyclohexane dimethanol divinyl ether, trivinyl ethers, and the like. It is preferred that alkyl vinyl ethers with up to 3 carbon alkyl groups and one – to three – carbon alkyl (alkyl vinyl) ethers with alkyl vinyl groups of up to 8 carbon atoms are used.

Illustrative of suitable acroleins useful in preparing the liquid hydrocarbon diols include, among others, acrolein; 2 – ethyl – 2 – butenal; 2 – methyl – 2 – butenal; 2 – (n – propyl) – 2 – butenal; 2 – (i – propyl) – 2 – butenal; 2 – methyl – 2 – pentenal, which has the structure:

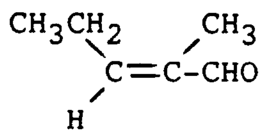

;

2 – ethyl – 2 – pentenal; 2 – (n – propyl) – 2 – pentenal; 2 – (i – propyl) – 2 – pentenal; 2 – (n – butyl) – pentenal; 2 – (i – butyl) – pentenal; 2 – (s – butyl) – pentenal; 2 – (t – butyl) – pentenal; 2 – amyl pentenals; 2 – ethyl – 2 – hexenal, which has the structure:

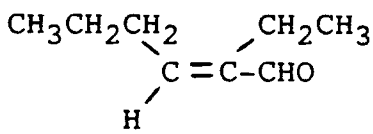

;

2 – methyl – 2 – hexenals; 2 – (n – propyl) – 2 – hexenals; 2 – (i – propyl) – 2 – hexenals; 2 – (n – butyl) – 2 – hexenals; 2 – (i – butyl) – 2 – hexenals; 2 – (s – butyl) – 2 – hexenals; 2 – (t – butyl) – 2 – hexenals; 2 – amyl hexenals; and the like.

Illustrative of suitable substituted 3,4 – dihydropyrans prepared in reaction step (a) above include, for example, 2 – alkoxy – 5 – ethyl – 4 – propyl – 3,4 – dihydro – 1,2 – pyran, 2 – alkoxy – 4 – ethyl – 5 – methyl – 3,4 – dihydro – 1,2 – pyran, 2 – alkoxy – 4 – ethyl – 3,5 – dimethyl – 3,4 – dihydro – 1,2 – pyran, 2 – alkoxy – 5 – ethyl – 3 – methyl – 4 – propyl – 3,4 – dihydro – 1,2 – pyran, 2 – alkoxy – 3,4 – diethyl – 5 – methyl – 3,4 – dihydro – 1,2 – pyran, 2 – alkoxy – 4 – ethyl – 3,3',5 – trimethyl – 3,4 – dihydro – 1,2 – pyran, 2 – alkoxy – 3,3' – dimethyl – 4 – propyl – 3,4 – dihydro – 1,2 – pyran, 2 – alkoxy – 3 – methyl – 3' – propyl – 3,4 – dihydro – 1,2 – pyran, 2 – alkoxy – 4 – ethyl – 5 – methyl – 3 – methyl – 3' – propyl – 3,4 – dihydro – 1,2 – pyran, 2 – alkoxy – 5 – ethyl – 3 – methyl – 3',4 – dipropyl – 3,4 – dihydro – 1,2 – pyran, 2 – alkoxy – 3 – butyl – 3' – ethyl – 3,4 – dihydro – 1,2 – pyran, 2 – alkoxy – 3 – butyl – 3',4 – diethyl – 5 – methyl – 3,4 – dihydro – 1,2 – pyran, 2 – alkoxy – 3 – butyl – 3',5 – diethyl – 4 – propyl – 3,4 – dihydro – 1,2 – pyran, and the like. For purposes of these illustrative substituted 3,4 – dihydropyrans, alkoxy refers to methoxy, ethoxy, n – propoxy, isopropoxy, n – butoxy, i – butoxy, s – butoxy, t – butoxy, and the like.

The step (a) reaction can be conducted at a temperature of from about 160 ° C to 280 ° C for a period of about 1 hour to about 7 days with the longer time being used at the lower temperature, preferably from about 180 ° C to about 270 ° C for about 1 hour to about 5 days, and more preferably at about 200 ° C to 260 ° C for about 1 hour to about 48 hours. During the reaction, from less than 0.01 percent by weight to about 5 percent by weight of the total weight of the starting materials, preferably from about 0.01 percent by weight to about 2 percent by weight, of a free radical inhibitor can be added to the reaction mass. Illustrative of such free radical inhibitors are 2,6 – ditertiarybutyl – 4 – methyl phenol, hydroquinone, hydroquinone monomethyl ether, and the like. A particularly useful inhibitor is hydroquinone.

The step (a) reaction can be conducted over a wide range of pressures ranging from atmospheric pressure to superatmospheric pressures, e.g., from about 1 atmosphere to about 100 atmospheres or greater. It is preferable to conduct the step (a) reaction at pressures of from about atmospheric to about 75 atmospheres. The step (a) reaction is preferably effected in the liquid or vapor states or mixtures thereof.

The molar ratio of substituted vinyl ether to acrolein compound in the step (a) reaction is not narrowly critical and can range from about 0.05:1 or less to about 50:1 or greater, preferably from about 0.1:1 to

about 10:1.

Illustrative of acid catalysts suitable for ring opening of the substituted 3,4-dihydropyran intermediates to form substituted dialdehydes in accordance with reaction step (b) above are mineral acids, including sulfuric acid, hydrochloric acid, phosphoric acid, triflic acid and its salts, sulfonic acids; organic acids including acetic acid, chloroacetic acid, oxalic acid; crosslinked acidic resins such as the various ion exchange resins including Amberlite® CG-400, Amberlite® IR-118; Amberlite® IR120(plus), Dowex® MSC-1, Dowex® M-31, Dowex® M32, Dowex® 50X2-100, Dowex® 50X2-200, Dowex® 50X2-400, Dowex® 50X4-400, Dowex® 50X8-100, Dowex® 50X8-200, Dowex® 50X8-400, Nafion® 117, Nafion® 417, Nafion® NR50, Nafion® perfluorinated powder, similar crosslinked acidic resins; perfluorinated polymers which contain sulfonic acid groups such as XUS-40036.02 (Dow Chemical Company); and the like. The illustrative ion exchange resins above, as well as others, are available from Aldrich Chemical Company, Inc.

The acid catalysts employed in the ring-opening of the substituted 3,4-dihydropyran intermediates are preferably used in conjunction with water; alcohols such as methanol, ethanol, isopropanol, n-propanol, n-butanol, sec-butanol, isobutanol, and tert-butanol, amyl alcohols as well as higher alcohols; glycol ethers such as ethoxy ethanol, methoxy ethanol, 1-methoxypropane, methoxyethoxy ethanol; glyme; and the like, as well as mixtures of water and other solvents. The amount of acid catalyst used in reaction step (b) is dependent on the particular catalyst employed and can range from about 0.01 weight percent or less to about 10 weight percent or greater of the total weight of the starting materials.

The acid dialdehyde reaction mass can be washed with water and/or aqueous solution of neutralizing agents. Illustrative of such neutralizing agents are sodium acetate, potassium acetate, sodium bicarbonate, sodium carbonate, potassium bicarbonate, potassium carbonate, and the like.

Illustrative of suitable substituted dialdehydes prepared in reaction step (b) above include, for example, 3-ethyl-2-methyl-1,5-pentanedial, 2-ethyl-3-propyl-1,5-pentanedial, 3-ethyl-2,4-dimethyl-1,5-pentanedial, 2-ethyl-4-methyl-3-propyl-1,5-pentanedial, 3,4-diethyl-2-methyl-1,5-pentanedial, 3-ethyl-2,4,4'-trimethyl-1,5-pentanedial, 2-ethyl-4,4'-dimethyl-3-propyl-1,5-pentanedial, 2-methyl-2'-propyl-1,5-pentanedial, 3-ethyl-2,4-dimethyl-4'-propyl-1,5-pentanedial, 2-ethyl-4-methyl-3,4'-dipropyl-1,5-pentanedial, 2-butyl-2'-ethyl-1,5-pentanedial, 4-butyl-3,4-diethyl-2-methyl-1,5-pentanedial, 4-butyl-2,4'-diethyl-3-propyl-1,5-pentanedial, and the like.

The step (b) reaction can be conducted over a wide range of pressures ranging from atmospheric or subatmospheric pressures to superatmospheric pressures, e.g., from about 1 atmosphere or less to about 25 atmospheres or greater. It is preferable to conduct the step (b) reaction at pressures of from about 1 atmosphere to about 10 atmospheres. The step (b) reaction is preferably effected in the liquid or vapor states or mixtures thereof.

The temperature of the step (b) reaction may be as low as about ambient temperature to about 300°C. Preferably, the reaction temperature ranges from about 50°C to about 200°C, and more preferably from about 60°C to about 120°C.

Illustrative of catalysts useful in the hydrogenation step (c) involving reduction of substituted dialdehydes include, for example, Raney-type compounds such as Raney nickel and modified Raney nickels; molybdenum-promoted nickel, chromium-promoted nickel, cobalt-promoted nickel; platinum; palladium; iron; cobalt molybdate on alumina; copper chromite; barium promoted copper chromite; tin-copper couple; zinc-copper couple; aluminum-cobalt; aluminum-copper; and aluminum-nickel; platinum; nickel; and the like. The amount of hydrogenation catalyst used in step (c) is dependent on the particular catalyst employed and can range from about 0.01 weight percent or less to about 10 weight percent or greater of the total weight of the starting materials.

The particular reaction conditions for the step (c) hydrogenation reaction are not narrowly critical, and can be any effective hydrogenation procedures sufficient to produce the substituted 1,5-pentanediols of this invention. The step (c) reaction can be carried out at temperatures of from about ambient temperature to about 250°C, preferably from about 70°C to about 200°C, and more preferably from 90°C to 150°C. The step (c) reaction preferably may be conducted at pressures of from about 5 atmospheres to about 100 atmospheres, and more preferably from about 10 atmospheres to about 75 atmospheres.

Illustrative of suitable substituted 1,5-pentanediols useful in preparing the conformal coating compositions of this invention include, for example, 3-ethyl-2-methyl-1,5-pentanediol, 2-ethyl-3-propyl-1,5-pentanediol, 2,4-dimethyl-3-ethyl-1,5-pentanediol, 2-ethyl-4-methyl-3-propyl-1,5-pentanediol, 2,3-diethyl-4-methyl-1,5-pentanediol, 3-ethyl-2,2,4-trimethyl-1,5-pentanediol, 2,2-dimethyl-4-ethyl-3-propyl-1,5-pentanediol, 2-methyl-2-propyl-1,5-pentanediol, 2,4-dimethyl-3-ethyl-2-propyl-1,5-pentanediol, 2,3-dipropyl-4-ethyl-2-methyl-1,5-pentanediol,

2-butyl-2-ethyl-1,5-pentanediol, 2-butyl-2,3-diethyl-4-methyl-1,5-pentanediol, 2-butyl-2,4-diethyl-3-propyl-1,5-pentanediol, 3-butyl-2-propyl-1,5-pentanediol and the like, including mixtures thereof.

Illustrative derivatives based on the liquid hydrocarbon diols that are useful in the coating compositions of the invention include, for example, polyesters, silicone-containing compounds, polyols initiated with said diols, and the like, including mixtures thereof. This invention is not intended to be limited in any manner by the permissible derivatives of liquid hydrocarbon diols.

The polyester derivative products useful in the coating compositions of this invention include, for example, those represented by the structural formula:

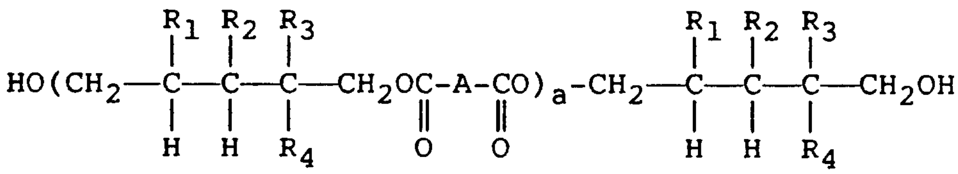

(III)

wherein $R_1$ is the same or different and is hydrogen or linear or branched alkyl having from 1 to 3 carbon atoms, $R_2$, $R_3$ and $R_4$ are the same or different and are hydrogen or linear or branched alkyl having from 1 to 4 carbon atoms, A is the same or different and is a substituted or unsubstituted hydrocarbon residue, preferably aryl such as phenylene, substituted phenylene, alkyl, cyclohexyl, substituted cyclohexyl and the like, and a is a value from about 1 to about 300 or greater, preferably from 1 to about 150, and more preferably from about 1 to about 75 or less.

Optionally, up to about 60 weight percent, preferably up to about 40 weight percent of other di-, tri-, tetra-, and higher-functionality polyols may be used in combination with the liquid hydrocarbon diols of Formula II to form the polyesters of Formula III. Suitable polyols include, for example, ethylene glycol, diethylene glycol, propylene glycol, dipropylene glycol, polyoxypropylene diols and triols, neopentyl glycol, esterdiols such as Esterdiol-204 and ethoxylated and propoxylated esterdiols, ethylene oxide/propylene oxide copolymer polyols, polyether polyols, polycarbonate polyols, poly(alkylene oxide) polyols, 1,3-propanediol, 1,4-butanediols, poly(tetramethylene oxide) polyols, 1,5-pentanediols other than those of Formula I or Formula II, 1,6-hexanediols, 2-ethyl-1,3-hexanediol, 1,7-heptanediol, and higher linear and branched hydrocarbon diols, polylactone diols and triols such as the poly-$\epsilon$-caprolactone polyols; halogenated diols such as 3-chloro-1,2-propanediol, 2,3-dibromo-1,4-butanediol; triols and higher hydroxyl-functional polyols such as trimethylolpropane, pentaerythritol, dipentaerythritol, sorbitol, sucrose; hydroquinone and substituted hydoquinones, bisphenols such as Bisphenol A, Bisphenol C, Bisphenol F, as well as others; 1,2-cyclohexanediols, 1,3-cyclohexanediols, 1,4-cyclohexanediols, 1,4-cyclohexane dimethanol, xylenediols, 2,2,4,4-tetramethyl-1,3-cyclobutanediol, and the like, including mixtures thereof.

Illustrative of the polyfunctional carboxylic acids that can be used to prepare the polyester derivative products useful in the coating compositions of this invention include, for example, oxalic acid, malonic acid, succinic acid, glutaric acid, adipic acid, pimelic acid, suberic acid, azelaic acid, sebacic acid, undecanedioic acid, dodecanedioic acid, tridecanedioic acid, maleic acid, fumaric acid, 2-methyl-cis-2-butenedioic acid, 2-methylenesuccinic acid, 1,1-cyclobutanedicarboxylic acid, norcamphoric acid, tetrahydrophthalic acid, methyl-tetrahydrophthalic acid, 1,1-cyclohexanedicarboxylic acid, hexahydrophthalic acid, 1,4-cyclohexanedicarboxylic acid, chlorendic acid, 1,4-benzenediacetic acid, phthalic acid, isophthalic acid, trimellitic acid, any other polyfunctional carboxylic acid including those having substituents thereon such as alkyl or alkoxy groups, nitro, halogen, aryl, carboxyl or any other group that will not unduly interfere with the reaction and the like as well as mixtures of such acids and mixtures of such acids with acid anhydrides.

Illustrative of the acid anhydrides that can be used to prepare the polyester derivative products useful in the coating compositions of this invention include, for example, trimellitic anhydride, tetrahydrophthalic anhydride, phthalic anhydride, isophthalic anhydride, benzophenone dicarboxylic acid anhydride, succinic anhydride, glutaric anhydride, napthoic anhydride, clorendic anhydride, itaconic anhydride, maleic anhydride, or any other intramolecular anhydride including those having substituents thereon such as alkyl or alkoxy groups, nitro, halogen, aryl, carboxyl or any other group that will not unduly interfere with the reaction and the like as well as mixtures of anhydrides or mixtures of anhydrides and polyfunctional carboxylic acids.

The polyester derivatives can be prepared by heating conventional amounts of the liquid hydrocarbon diols, optional polyols, polyfunctional carboxylic acids and/or acid anhydrides at an elevated temperature and removing water of condensation. The process of condensation is rate enhanced if catalysts are used. The catalysts that may be used to prepare the polyesters useful in the compositions of this invention are those known to persons skilled in the art of polyester preparation, illustrative of which are dibutyltin oxide, antimony oxide, tin oxide, titanium alkoxides, alkali metal salts or metallic salts of manganese, cadmium, magnesium, zinc, cobalt, tin, and the like.

The silicone-containing derivative compounds useful in the coating compositions of the invention can be prepared by conventional methods by either end capping, coupling, or other reaction when Formula II liquid hydrocarbon diols or mixtures of Formula II liquid hydrocarbon diols and optionally other polyols are reacted with silanes. Illustrative of the silane-containing derivative compounds include, for example, the following:

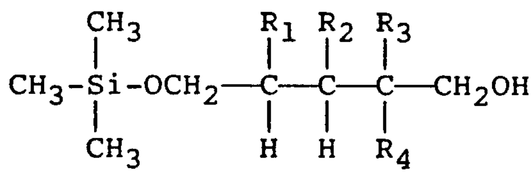

when 1 mole of trimethylchlorosilane and 1 mole of Formula II diol are reacted,

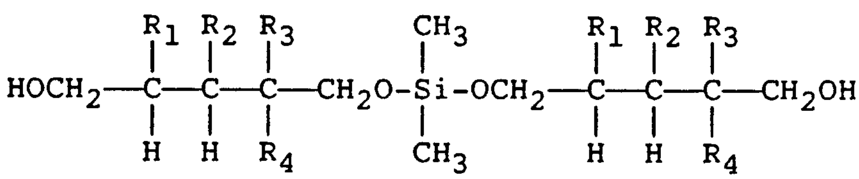

when one mole of dimethyldichlorosilane and two moles of Formula II diol are reacted,

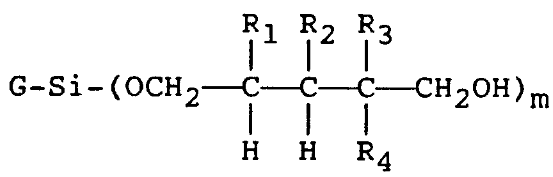

wherein $R_1$, $R_2$, $R_3$ and $R_4$ are as defined above, m is 3 or 4 and G is methyl when m is 3 and nonexistent when m is 4 when 3 moles (m = 3) or 4 moles (m = 4) of Formula II diol are reacted with methyltrichlorosilane or tetrachlorosilane respectively, and the like. It is preferred that the silane-containing product have residual hydroxyl groups. It is understood by those skilled in the art that when polyfunctional compounds are combined, a variety of products, including chain extended products, can be obtained. Illustrative of the silanes that can be used to produce the silane-containing compounds useful in the compositions of the invention include, for example, chloroalkylchloro and arylchlorosilanes, diphenylethylchlorosilane, trimethylchlorosilane, dimethyldichloromethylsilane, triphenylchlorosilane, methyldichlorosilane, dimethylethylchlorosilane, dichlorosilane; alkoxysilanes such as methoxysilane, dimethoxysilane, diethyoxysilane, triethoxysilane, dimethylmethoxychlorsilane, dimethylmethoxysilane, tris(methoxy)-3-chloropropylsilane, and the like, including mixtures thereof.

Illustrative polyols that can be used in combination with the Formula II liquid hydrocarbon diols in preparation of the silicone-containing derivative products useful in this invention, include, for example, diethylene glycol, 1,4-butanediol, 1,6-hexanediol, 1,4-dihydroxyquinone, 2,2-dimethyl-1,3-propanediol, hydroxyl-terminated polyesters, ethylene oxide/propylene oxide copolymer polyols, poly(ethylene oxide) polyols, poly(alkylene oxide) polyols, polyether polyols, poly(tetramethylene oxide) polyols, polycarbonate polyols, polylactone polyols, and the like, including mixtures thereof.

The polyol derivative products formed by ring-opening polymerization and initiated with the liquid hydrocarbon diols of Formula II and useful in the coating compositions of the invention include, for example,

polyols formed by reaction of one mole of the Formula II compound and from about one to about 10 moles of ϵ – caprolactone, substituted ϵ – caprolactone, δ – valerolactone, substituted δ – valerolactones, or a mixture of such lactones or other copolymerizable lactones; or from 1 to about 10 moles of propylene oxide, epichlorohydrin, 1,2 – butylene oxide, or ethylene oxide or mixtures of such oxides, with it preferred that from 1 to about 4 moles of ethylene oxide by used alone or in the mixtures. If desired both alkylene oxide and lactone units can be present in the polyols. Methods of preparation of such polyols are well known to those skilled in the art of lactone or alkylene oxide polymerization.

The amount of liquid hydrocarbon diol and/or derivative products based on said liquid hydrocarbon diols, included in the curable conformal coating compositions can range from about 1 or less to about 40 percent by weight, preferably from about 1 or less to about 20 percent by weight of the total composition, with it understood that in most instances a higher weight percentage will be used as the molecular weight of the diol or diol dirivative product is increased.

Suitable cycloaliphatic epoxides that are useful in the curable conformal coating compositions of this invention include those having an average of one or more epoxide groups per molecule with it preferred that the cycloaliphatic epoxides have two or more epoxide groups per molecule. The cycloaliphatic epoxide can be a mixture of epoxides that will usually contain a major proportion of cycloaliphatic epoxides with two or more epoxy groups per molecule. Illustrative of suitable cycloaliphatic epoxides include the following:

A 3,4 – epoxycyclohexylmethyl 3,4 – epoxycyclohexanecarboxylate having the formula:

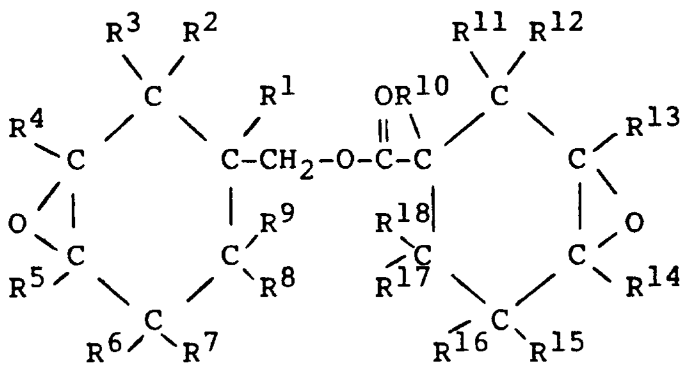

(IV)

wherein $R^1$ through $R^{18}$ which can be the same or different are hydrogen or alkyl radicals generally containing one to five carbon atoms inclusive, and preferably containing one to three carbon atoms inclusive, as for example methyl, ethyl, n – propyl, i – propyl, n – butyl, s – butyl, i – butyl, t – butyl, amyls, and the like. Particularly desirable compounds are those wherein $R^1$ through $R^{18}$ are hydrogen. Among specific compounds falling within the scope of Formula IV are the following:

3,4 – epoxycyclohexylmethyl 3,4 – epoxycyclohexane carboxylate; 3,4 – epoxy – 1 – methylcyclohexylmethyl 3,4 – epoxy – 1 – methylcyclohexane carboxylate; 6 – methyl – 3,4 – epoxycyclohexylmethyl 6 – methyl – 3,4 – epoxycyclohexane carboxylate; 3,4 – epoxy – 3 – methylcyclohexylmethyl 3,4 – epoxy – 3 – methylcyclohex – ane carboxylate; 3,4 – epoxy – 5 – methylcyclohexylmethyl 3,4 – epoxy – 5 – methylcyclohexane carboxylate. Other suitable compounds are described in, for example, U.S. Patent No. 2,890,194.

Diepoxides of cycloaliphatic esters of dicarboxylic acids having the formula:

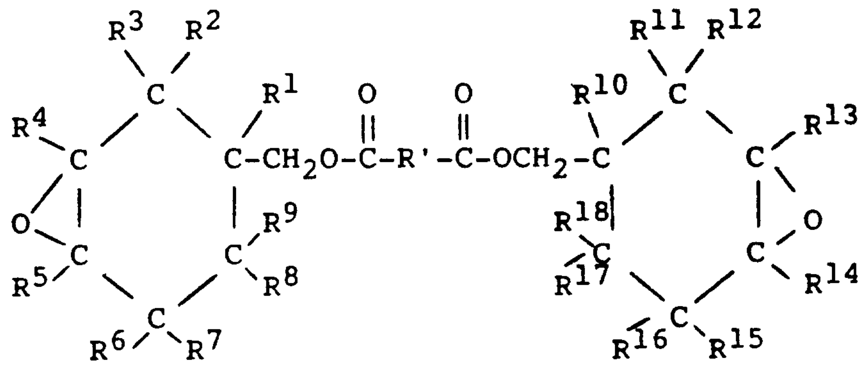

(V)

where $R^1$ through $R^{18}$ which can be the same or different are as defined for $R^1$ through $R^{18}$ in Formula IV above; R' is a valence bond or a divalent hydrocarbon radical generally containing one to 18 carbon atoms, inclusive, and preferably, containing 4 to 12 carbon atoms, inclusive, as for example alkylene radicals, such as trimethylene, tetramethylene, pentamethylene, hexamethylene, 2-ethylhexamethylene, octamethylene, nonamethylene, and the like; cycloaliphatic radicals such as 1,4-cyclohexane, 1,3-cyclohexane, 1,2-cyclohexane, Formula I and Formula II compounds without their primary hydroxyl groups, and the like. Particularly desirable epoxides, falling within the scope of Formula V, are those wherein $R^1$ through $R^{18}$ are all hydrogen and R' is alkylene containing four to six carbon atoms.

Among specific diepoxides of cycloaliphatic esters of dicarboxylic acid are the following: bis(3,4-epoxycyclohexylmethyl)oxylate, bis(3,4-epoxycyclohexylmethyl)adipate, bis(3,4-epoxy-6-methylcyclohexylmethyl) adipate, bis(3,4-epoxycyclohexylmethyl)pimelate, bis(3,4-epoxycyclohexylmethyl)-2-ethyl-3-propyl-1,5-pentanoate, and the like. Other suitable compounds are described in, for example, U.S. Patent No. 2,750,395.

Other cycloaliphatic diepoxides include 2-(3,4-epoxycyclohexyl-5,5-spiro-3,4-epoxy)-cyclohexane-m-dioxane, halogen or monovalent hydrocarbon variations of this compound, and the like as further defined in U.S. Patent No. 3,318,822; cyclopentadiene diepoxide, cyclohexane diepoxide, and the like.

The coating compositions may include from about 1 or less to about 20 weight percent of a cycloaliphatic monoepoxide that functions as a reactive diluent and contributes to overall coating properties. This monoepoxide may be an unsubstituted monoepoxide such as cyclohexene oxide or a substituted monoepoxide with alkyl groups of 1 to 6 carbon atoms, halogen, ester groups, vinyl groups, and the like. Examples of substituted monoepoxides include, for example, limonene monoepoxide, vinyl 3,4-epoxycyclohexane, norbornene monoepoxide, alpha-pinene monoepoxide, and the like. Preferably, the substituted monoepoxide is a vinyl substituted or an alkyl substituted monoepoxide and is preferably selected from one or more of the following: vinyl 3,4-epoxycyclohexane, vinyl 3,4-epoxynorbornene, or limonene monoepoxide.

The preferred cycloaliphatic diepoxides are 3,4-epoxycyclohexylmethyl 3,4-epoxycyclohexane carboxylate, bis(3,4-epoxycyclohexylmethyl)adipate, bis(3,4-epoxycyclohexylmethyl)-2-ethyl-3-propyl-1,5-pentanoate, or mixtures thereof.

It is preferred to employ from about 50 or less to about 98 weight percent of cycloaliphatic epoxide, preferably from about 60 to about 95 weight percent, in the curable conformal coating compositions of this invention.

If desired, minor amounts of up to about 15 weight percent of glycidyl epoxides such as the diglycidyl ethers of Bisphenol-A, diglycidyl ethers of brominated Bisphenol-A; cresol-novolac epoxy resins, epoxy phenol novolac resins; diglycidyl ethers of 1,4-butanediol, and the like can be used.

Other compounds useful in formulating the conformal coating compositions of the invention include vinyl esters containing a total of 8 or more carbon atoms. Illustrative of the vinyl esters include, for example, vinyl 2-ethylhexanoate, vinyl hexanoates, vinyl benzoate, vinyl isovalerate, vinyl crotonate, vinyl octylates, vinyl nonylates, vinyl neononanoate, vinyl neodecanoate, vinyl laurate, vinyl ketostearate, vinyl stearate, vinyl myristate, vinyl palmitate, vinyl oleate, vinyl 9-hydroxystearate, vinyl 9,10-dihydroxystearate, vinyl linoleate, vinyl linolenate, vinyl cinnamate, vinyl napthoates, vinyl versatates which are commercial products and known to contain mixtures of vinyl esters, divinyl adipate, divinyl succinate, divinyl adipate, divinyl

sebacate, divinyl phthalate, divinyl isophthalate, divinyl terephthalate, divinyl pinate, divinyl diglycolate, divinyl brassylate, divinyl glutaconate; divinyl glycarates; divinyl sebacate, diisopropenyl adipate [$CH_2=C-(CH_3)OCO(CH_2)_4OCOC(CH_3)=CH_2$], divinyl 3,6-dichlorophthalate, trivinyl mellititate, trivinyl citrate, 1,1,5-trivinyl pentanoate, trivinyl hemimellitate, trivinyl mesate, 1,2,4-trivinyl benzenetricarboxylate, and the like; higher vinyl esters illustrative of which one can mention tetravinyl prehnitate, tetravinyl mellophanate, tetravinyl pyromellitate, 1,3,4,5-tetravinyl-2-carboxylic acid benzoate, 3,3',4,4'-tetravinyl benzophenonetetracarboxylate, and the like, including mixtures thereof. From about 0 to about 15 percent by weight of vinyl esters may be used in the curable conformal coating compositions of this invention.

The polyols that can be used in the conformal coating compositions of the invention include, for example, polylactone polyols, polyester polyols, polyether polyols, poly(alkylene oxide) polyols, poly(tetramethylene oxide) polyols, polycarbonate polyols, and the like, including mixtures thereof. From about 0 to about 50 weight percent of polyol may be used in the conformal coating compositions of this invention.

The polylactone and polyester polyols are the dihydroxyl, trihydroxyl, tetrahydroxyl, hexahydroxyl, and higher hydroxyl-functional polyols having a number average molecular weight of about 200 to about 5000 and a hydroxyl number of about 20 to about 560. Illustrative polylactone polyols include those based on a suitable initiator and epsilon-caprolactone, delta-valerolactone, zeta-enantholactone, eta-caprylolactone as well as substituted lactones such as methyl caprolactone, t-butyl-caprolactone, and the like. Illustrative of the polyester polyols include the condensation products of multifunctional polyols and multifunctional carboxylic acids such as the adipates of ethylene glycol, diethylene glycol, 1,3-propanediol, 1,4-butanediol, 1,6-hexanediol, neopentyl glycol, and the like.

Illustrative of the polyether polyols useful in the curable conformal coating compositions of this invention include the polyhydroxyalkanes and polyoxyalkylene polyols and the like. Among the polyoxyalkylene polyols which can be employed are those selected from one or more of the following classes of compositions alone or in admixture:

(a) Alkylene oxide adducts of polyhydroxyalkanes;

(b) Tetramethylene oxide polyols prepared from tetrahydrofuran which have the repeating unit

$-(CH_2)_4-O-$.

Illustrative alkylene oxide adducts of polyhydroxyalkanes include, among others, the alkylene oxide adducts of ethylene glycol, propylene glycol, 1,3-dihydroxypropane, glycerol, 1,1,1-trimethylol- propane, 1,1,1-trimethylolethane, pentaerythritol, dipentaerythritol, polycaprolactone, xylitol, sorbitol, mannitol, and the like. A preferred class of alkylene oxide polyols from the polyhydroxyalkanes are the propylene oxide, butylene oxide, or mixtures thereof alone or in combination with 10 percent or less of ethylene oxide, adducts of trihydroxyalkanes including poly(oxypropylene) glycols, poly(oxybutylene) polyols, poly(oxyethylene-oxypropylene) polyols including random and block copolymers, poly(oxyethylene-oxybutylene) polyols including random and block copolymers, poly(oxypropylene-oxybutylene) polyols including random and block copolymers, and poly(oxyethylene-oxypropylene-oxybutylene) copolymers including random and block copolymers. In the random and block copolymers, the comonomer can be incorporated in any fashion along the polyol chain including, for example, propylene oxide polyols capped with ethylene oxide, and the like.

Illustrative of the tetramethylene oxide polyols include the dihydroxyl functional polytetramethylene oxide polyols such as POLYMEG® 650, 1000, 2000 available from Quaker Chemical Company and TERETHANE®-650, 1000, 2000, and 2900 available from E.I. Dupont de Nemours Company.

Illustrative of the onium salt photoinitiators useful in this invention one can mention one or more of a metal fluoroborate and a complex of boron trifluoride as described in U.S. Patent No. 3,379,653; a bis-(perfluoro-alkylsulfonyl) methane metal salt, as described in U.S. Patent No. 3,586,616; an aryl diazonium compound as described in U.S. Patent No. 3,708,296; an aromatic onium salt of Group VIa elements as described in U.S. Patent No. 4,058,400; an aromatic onium salt of Group Va elements as described in U.S. Patent No. 4,069,055; a dicarbonyl chelate of a Group IIIa-Va element as described in U.S. Patent No. 4,068,091; a thiopyrylium salt as described in U.S. Patent No. 4,139,655; a Group VIb element in an $MF_6$ anion where M is selected from phosphorous, antimony, and arsenic as described in U.S. Patent No. 4,161,478; an arylsulfonium complex salt as described in U.S. Patent No. 4,231,951; an aromatic iodonium complex salt and an aromatic sulfonium complex salt, as described in U.S. Patent No. 4,256,828; and a bis(4-(diphenylsulfonio)phenyl)sulfide-bis-hexafluoro-metallic salts such as the phosphate, arsenate, antimonate and the like as described by W. R. Watt and coworkers in J. Polymer Sci.: Polymer Chem. Ed., 22, 1789 (1984). Preferred cationic photoinitiators include the arylsulfonium or arylidodonium complex salts, aromatic sulfonium or iodonium salts of halogen containing complex ions, and aromatic onium salts of

Group II, V, and VI elements. Some of such salts are commercially available in a solution form as FX-512, thought to be a multiarylsulfonium hexafluorophosphate, from 3M Co.; CYRACURE® UVI-6990 and UVI-6974, multiarylsulfonium hexafluorophosphate and multiarylsulfonium hexafluoroantimonate, respectively, from Union Carbide Chemicals and Plastics Company Inc.; UVE-1014 and UVE-1016, multiarylsulfonium hexafluorophosphate and multiarylsulfonium hexafluoroantimonate, respectively, from General Electric Co., KI-85, thought to be bis(4-(diphenylsulfonio) phenyl)sulfide-bis-hexafluoro-phosphate, from Degussa AG; and SP-150 and SP-170, thought to be bis(4-(diphenylsulfonio)phenyl) sulfide-bis-hexafluorophosphate and bis(4-(diphenylsulfonio)phenyl)-sulfide-bis-hexafluoroantimonate, respectively, from Asahi Denka Kogyo K.K. The onium salt photoinitiators are used in the curable conformal coating compositions of this invention at a concentration of about 0.01 weight percent to about 10 weight percent, preferably at concentrations of about 0.25 weight percent to about 5 weight percent, of the total composition.

Although photolysis of the onium salts described above results in the generation of cations, it also results in the formation of free radical species that can initiate polymerization of ethylenic unsaturation such as that found on acrylates, vinyl esters, and styrene. However, if desired, a photoinitiator that generates only free radicals when photolyzed with ultraviolet light can be optionally used. Illustrative of such photoinitiators are 2,2-diethoxyacetophenone, acetophenone, benzil dimethylketal, 2,2-dimethoxy-2-phenylacetophenone, 1-hydroxycyclohexyl phenyl ketone, benzophenone and optionally an appropriate synergist, and the like. When used in the conformal coating compositions, said photoinitiators are used at about 1 to about 5 weight percent.

If desired, the conformal coatings may contain acrylates such as the monoacrylates, illustrative of which are hydroxyethyl acrylate, hexyl acrylate, and the like; the multifunctional acrylates, illustrative of which are hexanediol diacrylate, trimethylolpropane triacrylate, pentaerythritol tri- and tetraacrylates, the urethane acrylates, and the epoxy acrylates. Also optional are minor amounts of the vinyl ethers such as triethylene glycol vinyl ether, 1,4-dimethanol cyclohexane divinyl ether, and the like. Such ingredients can be used in conventional amounts known in the art.

Thermal catalysts that may be used in the conformal coatings of this invention include triflic acid salts, other blocked Bronsted acids when reasonable shelf lives or pot lives are desired, and other unblocked Bronsted acids when length of shelf life or pot life is unimportant, and the like. Illustrative of the thermal catalysts that can be used to cure the conformal coating compositions of this invention are para-toluene sulfonic acid, triflic acid salts, boron trifluoride etherate, boron trifluoride, sulfonium salts, and the like. Illustrative of the triflic acid salts are diethylammonium triflate, ammonium triflate, di-isopropylammonium triflate, and the like. These catalysts are usually used at concentration of about 0.05 weight percent to about 1 weight percent of the total composition.

In addition, the curable conformal coating compositions can contain additives in conventional amounts that are known to those skilled in the art of coating formulation. Illustrative of such additives are surfactants such as the silicone-, silicone/alkylene oxide-, and fluorochemical-type surfactants; chemicals that will fluoresce under ultraviolet light such as Calcafluor White RWP (American Cyanamide); thickening agents such as the silicas; colorants; inert solvents, and the like.

The curable coating compositions are prepared by blending the various ingredients in a suitable mixing vessel. When the photoinitiator component is added to the mixture, yellow light conditions or other conditions that will ensure the absence of ultraviolet light should be employed for safety and for storage stability purposes. The compositions should be protected from ultraviolet light until they are exposed to such light in the curing process. The curing process is accomplished by actinic energy, particularly ultraviolet light energy when the onium salt photoinitiators are used. When thermal catalysts are employed, the curing process is accomplished in a thermal oven including infrared ovens.

The curable coating compositions of this invention are particularly useful as conformal coatings which are used in the electronics industry, though the coating compositions can have a variety of other functional and decorative uses on various substrates illustrative of which are overprint varnishes on paper, wood, plastic, steel, copper; printing inks, can coatings, and the like. When used as conformal coatings in the electronics industry, they can be coated over an entire printed circuit board and its components to provide an encapsulated system, over a portion of the printed circuit board, or over selected components on the printed circuit board and cured to provide an system encapsulated by a solid film that is protected from a variety of hostile environments. These environments include moisture, high humidity conditions, standing water or snow, high temperature and humidity conditions, dust ionic contaminants, fungi, mildew, and the like. Further, the conformal coatings of this invention provide enhancement of electrical circuit reliability over extended time periods. At times the conformal coating may only cover portions of the printed circuit board as, for example, over only the solder connections which are usually found on the noncomponent side of the

board. At other times the conformal coating may be coated and cured on individual components, for example, on an integrated circuit to proved resistance to hostile environments or against electrical arcing or against some other destructive mechanism.

Other attributes of the cured conformal coating compositions of this invention include clean burning, that is, they burn cleanly without charring, during repair or arcing on the board. Usually, a conformally coated printed circuit board is repaired by burning though the conformal coating with a soldering iron or hot flame device and thus melt the solder holding the defective component allowing removal and replacement. If the coating is charred, it will be a place of high conductivity and electrical losses can occur in such areas. If charring takes place during electrical arcing along the printed circuit boards surface, this increases electrical conductivity and is not desirable since losses can occur. Conformal coatings based on aromatic epoxides such as the diglycidyl ether of 2,2-bis(p-hydroxyphenyl)propane, char when subjected to a burning operation or surface electrical arcing. This results in unsightly and conductive resides which deleteriously affect the electrical properties of the electrical/electronic device.

As used herein, the term "polyol" is contemplated to include all permissible hydrocarbon compounds having 2 or more hydroxyl groups, e.g., diols, triols and the like.

For purposes of this invention, the term "hydrocarbon" is contemplated to include all permissible compounds having at least one hydrogen and one carbon atom. In a broad aspect, the permissible hydrocarbons include acyclic and cyclic, branched and unbranched, carbocyclic and heterocyclic, aromatic and nonaromatic organic compounds which can be substituted or unsubstituted.

As used herein, the term "substituted" is contemplated to include all permissible substituents of organic compounds unless otherwise indicated. In a broad aspect, the permissible substituents include acyclic and cyclic, branched and unbranched, carbocyclic and heterocyclic, aromatic and nonaromatic substituents of organic compounds. Illustrative substituents include, for example, alkyl, alkyloxy, aryl, aryloxy, hydroxy, hydroxyalkyl, amino, aminoalkyl, halogen and the like in which the number of carbons can range from 1 to about 20 or more, preferably from 1 to about 12. The permissible substituents can be one or more and the same or different for appropriate organic compounds. This invention is not intended to be limited in any manner by the permissible substituents of organic compounds.

Certain of the following examples are provided to further illustrate this invention.

## Glossary of Terms

Electrical Insulation Resistance - This electrical property is a measure of the electrical resistance property or resistance offered by the material to passage of an electrical current. The measurements were made in accordance with method 302, test condition B, of Military Standard 202. Insulating materials are very poor conductors of electricity and offer high resistance and thus the higher the value, the better the insulating property of a material. When temperature increases, insulating resistance decreases. When moisture content of a coating as might be encountered under high humidity conditions increases, insulation resistance decreases. Coatings with a high insulation resistance and the ability to maintain such resistance under high humidity conditions are useful protectors of electrical circuitry.

Double Rubs - Solvent resistance was measured as the number of solvent (methyl ethyl ketone or acetone) double rubs that were required to cut through the coating. If 100 rubs or more did not cut through the coating, the coating was recorded as >100. To perform the test, the solvent-soaked cloth was rubbed back and forth with hand pressure. A rub back and forth was designated as one "double rub".

Pencil Hardness - Procedure conducted in accordance with ASTM D 3363-74.

Crosshatch Adhesion - Procedure conducted in accordance with ASTM D 3359-87.

Epoxide I - 3,4-Epoxycyclohexylmethyl 3,4-epoxycyclohexanecarboxylate commercially available from Union Carbide Chemicals and Plastics Company Inc. as ERL-4221 and CYRACURE® UVR-6110.

Epoxide II - Vinyl 3,4-epoxycyclohexane.

Epoxide III - A cycloaliphatic epoxide product with a viscosity of 100 centipoise at 25°C and commercially available from Union Carbide Chemicals and Plastics Company Inc. as CYRACURE® URV-6100.

Polyol I - A 1,000 number-average molecular weight polytetramethylene oxide diol that was obtained from Aldrich Chemical Co.

Vinyl Ester I - A vinyl ester prepared from Versatic 10 which is a synthetic, saturated monocarboxylic acid with a highly branched structure that contains 10 carbon atoms and is commercially available from Shell Chemical Company as Veova® VV10.

Photoinitiator I - A cationic photoinitiator commercially available from Union Carbide Chemicals and Plastics Company Inc. as CYRACURE® UVI-6974.

Surfactant I – A hydroxy-terminated poly(ethylene oxide) modified polydimethylsiloxane commercially available from Union Carbide Chemicals and Plastics Company Inc. as SILWET® L-7604.

Conformal Coating I – A high quality, ultraviolet light curable conformal coating based on cycloaliphatic epoxides that passes Military Specification 46058C and commercially available from Union Carbide Chemicals and Plastics Company Inc. as ENVIBAR® UV-1244.

Example 1 and Control Example A

The ingredients listed in Table A below were weighed into amber-colored glass bottles and well mixed. Example 1 differs from Control A in that the poly(tetramethylene glycol) polyol is replaced with an equivalent amount, on a hydroxyl content basis, of 2-ethyl-3-propyl-1,5-pentanediol and reactive diluent Epoxide II has been replaced with reactive diluent Vinyl Ester I.

Table A

| Ingredients, grams | Examples | |
|---|---|---|
| | Control A* | 1 |
| Epoxide I | 7.353 | 8.208 |
| Epoxide II | 1.197 | --- |
| Polyol I | 1.211 | --- |
| 2-Ethyl-3-propyl-1,5-pentanediol | --- | 0.232 |
| Vinyl Ester I | --- | 1.335 |
| Photoinitiator I | 0.206 | 0.223 |
| Surfactant I | 0.006 | 0.008 |

*Control A is a composition disclosed in U.S. Patent No. 5,043,221.

Example 2 and Control B

The conformal coating compositions of Example 1 and Control A were coated onto Bonderite 37 steel with a No. 20 wire-wound rod, cured with one pass under a 300 watt-per-inch medium pressure mercury vapor lamp (American Ultraviolet Company equipment) at 30 feet-per-minute to form the cured coating of Example 2 and Control B, respectively. These cured coatings were tested for the properties in Table B below when measured at the indicated times after exposure. The results are given in Table B.

Table B

| Property (Time) | Example | |
|---|---|---|
| | Control B | 2 |
| **Double Acetone Rubs** | | |
| 1 Hour after UV Exposure | 38 | >100 |
| 24 Hours after UV Exposure | >100 | --- |
| **Pencil Hardness** | | |
| 2 Hours after UV Exposure | 2H | B |
| 24 Hours after UV Exposure | 2H | 2H |

Example 3 and Controls C and D

The conformal coating compositions of Example 1 and Control A were coated onto Y test pattern printed circuit boards by first cleaning the boards with a detergent solution and a soft brush, rinsing the

boards several times with distilled water while lightly scrubbing with a soft brush, and then rinsing with acetone. The boards were dried in a circulating-air oven at 65° C for 30 minutes. The resistance gap between the Y pattern was coated by pouring the coating compositions of Example 1 and Control A over just the Y pattern of the Y test pattern board (i.e., most of the board was not coated) and cured with one pass under a 300 watt-per-inch medium pressure mercury vapor lamp (American Ultraviolet Company equipment) at 30 feet-per-minute to form the cured coating of Example 3 and Control D, respectively. Control C is a cleaned, uncoated Y test pattern printed circuit test board (Military Specification 46058C). Data with this board is representative of a board that was cleaned in the same way but not coated and kept under the same environmental conditions as Control D and Example 3. After ultraviolet light exposure, the insulation resistance of the cured coatings was measured at various times while remaining at room temperature (67° C) and humidity conditions which were high but not measured and which varied from day to day. The results are given in Table C below.

Table C

| Time after UV Exposure and Any Additional Thermal Cure | Insulation Resistance x $10^{-12}$ | | |
|---|---|---|---|
| | Control C | Control D | Example 3 |
| 24 hrs under room conditions | 5.0 | 0.43 | 3.3 |
| 10 days under room conditions | 1.6 | 0.29 | 2.2 |
| 10 days under room conditions plus 1 hour in a 110° C oven | 50.0 | 45.0 | >100 |
| 2 Hrs under room conditions after oven post cure | 7.0 | 20.0 | >100 |
| 16 hrs under room conditions after oven post cure | 2.0 | 14.0 | >100 |
| 3 days under room conditions after oven post cure | 16.0 | 18.0 | >100 |

These results demonstrate that formulations containing the liquid hydrocarbon diol, 2-ethyl-3-propyl-1,5-pentanediol, and vinyl esters can protect printed circuit boards from hostile environments. The clean board, Control C, would be expected to have the best properties since air is an excellent electrical insulator in the absence of moisture in the environment or other conductive contaminant. In general this is true early in the test. However as the test progressed and the board was held under the humid laboratory environment, the Example 3 coated boards had better insulation resistance properties than either of the controls. This was particularly true after the post cure treatment, which was excessively long but designed to ensure that complete cure had taken place. After post curing, the coated samples always had insulation resistance values of >2.5 x $10^{12}$ which is the minimum value allowed by the above cited military specification. The coating containing the liquid hydrocarbon diol, 2-ethyl-3-propyl-1,5-pentanediol, Example 3, did not vary when it was exposed to the humid laboratory conditions, whereas the controls had day to day variations.

Examples 4 and 5

The ingredients listed in Table D below were weighed into amber-colored glass bottles and well mixed. The coatings were then applied to phosphatized steel panels, cured as described in Example 2, and tested for solvent resistance and hardness and to Y test pattern boards by pouring the coating composition over the board and letting the excess liquid coating drain from the coated substrate and tested for insulation resistance. Before coating, the boards were cleaned and cured as described in Example 3 and tested. The results are given in Table D.

Table D

| Ingredients, grams | Examples 4 | Examples 5 |
|---|---|---|
| Epoxide I | 2.60 | 2.90 |
| 2-Ethyl-3-propyl-1,5-pentanediol | 0.675 | 0.37 |
| Photoinitiator I | 0.721 | 0.782 |
| Surfactant I | 0.002 | 0.001 |
| **Properties On Phosphatized Steel 16 Hours After UV Exposure** | | |
| Double Acetone Rubs | >100 | >100 |
| Pencil Hardness | 2H | 2H |
| Percent Crosshatch Adhesion | 40 | 25 |
| **Properties on Y Test Pattern Board 24 Hours After UV Exposure** | | |
| Insulation Resistance, ohms x $10^{-12}$ | 3.6 | 5.0 |

Example 6

A polyester product was prepared by charging 75.2 grams (0.43 mole) of 2-ethyl-3-propyl-1,5-pentanediol, 3.5 grams (0.026 mole) of trimethylolpropane, 16.2 grams (0.10 mole) of isophthalic acid, 14.3 grams (0.10 mole) of adipic acid, and 0.22 grams (0.2 weight percent) dibutyltin oxide catalyst to a four-necked, one-liter round bottom flask equipped with a mechanical stirrer, thermometer, nitrogen sparging tube, and a simple distillation head. During the reaction, the ingredients were kept under a nitrogen sparge with stirring. The system was gradually heated to 160°C over a one-hour period. The temperature was maintained at 160°C with a Therm-O-Watch controller for one hour, and then the temperature was increased in 10 degree increments every 45 minutes until a reaction temperature of 220°C was attained. This temperature was maintained for 30 minutes after which the system was allowed to cool to room temperature. All water of condensation formed by the reaction was removed with the simple distillation head. The resulting polyester had a Brookfield viscosity of 5,440 centipoise at 23°C, an hydroxyl number of 258, and an acid number of 2.23. Molecular weight determination by gel permeation chromatography using a polystyrene standard resulted in an apparent number average molecular weight of 831, a weight-average molecular weight of 1161, and a polydispersity of 1.40.

A composition containing 3.75 grams of the polyester product, 18.5 grams of Epoxide I, 2.125 grams of Vinyl Ester I, 0.125 grams of Surfactant I, and 0.50 grams of Photoinitiator I was placed in an amber bottle, well mixed and cured on phosphatized steel and on cleaned Y test pattern boards in the manner described in Examples 2 and 3.

The cured coating passed 100 acetone double rubs, had 100 percent crosshatch adhesion, and a 2H hardness on the steel substrate. On the Y-pattern test board the insulation resistance was 40 x $10^{12}$ ohms.

Examples 7, 8 and Control E

The ingredients listed in Table E below were weighed into amber-colored glass bottles and well mixed. The mixtures were coated onto phosphatized steel, epoxy/fiberglass substrate that is used to manufacture FR-4 printed circuit boards, and on Y-pattern test boards. The coatings on steel and epoxy/fiberglass test board were prepared by the drawdown technique using a No. 20 wire-wound rod and the coatings on the Y-pattern test boards were prepared by a dipping technique in which the board was immersed in the liquid coating, removed, allowed to drain to remove excess material, and then cured. Curing was accomplished by exposing the coated substrates to a 300 watt-per-inch ultraviolet light source in the same manner as described in Example 2. The cured coatings were tested by the indicated tests in Table E and the results

are given in Table E.

Table E

| Ingredients, grams | Examples 7 | 8 | Control E |
|---|---|---|---|
| Epoxide III | 9.44 | 9.33 | ---- |
| 2-Ethyl-3-propyl-1,5-pentanediol | 0.34 | 0.45 | ---- |
| Photoinitiator I | 0.22 | 0.22 | ---- |
| Surfactant I | 0.005 | 0.005 | ---- |
| Conformal Coating I | ---- | ---- | 10.0 |
| Properties On Phosphatized Steel 24 Hours After UV Exposure | | | |
| Double Acetone Rubs | 100* | 100* | 100 |
| Pencil Hardness | 2H | 2H | 2H |
| Percent Crosshatch Adhesion | 100 | 100 | 0 |
| Properties On Epoxy/Fiberglass 5 Days After UV Exposure | | | |
| Percent Crosshatch Adhesion | 100 | 100 | 100 |
| Properties on Y Test Pattern Board 24 Hours After UV Exposure | | | |
| Insulation Resistance 2 Days After Ultraviolet Light Exposure, ohms x $10^{-12}$ | 0.51 | 0.72 | 0.16 |

*After 100 acetone double rubs, the coatings were very slightly scratched.

Although the invention has been illustrated by certain of the preceding examples, it is not to be construed as being limited thereby; but rather, the invention encompasses the generic area as hereinbefore disclosed. Various modifications and embodiments can be made without departing from the spirit and scope thereof.

Related Applications

The following are related, commonly assigned applications, filed on an even date herewith:

U.S. Patent Application Serial No. 790,875 (D-16840); U.S. Patent Application Serial No. 790,872 (D-16841); U.S. Patent Application Serial No. 790,896 (D-16843); U.S. Patent Application Serial No. 790,874 (D-16844); U.S. Patent Application Serial No. 790,895 (D-16845); all of which are incorporated herein by reference.

## Claims

1. A curable conformal coating composition comprising (i) a liquid hydrocarbon diol comprised of primary hydroxyl groups and 8 or more carbon atoms in which the primary hydroxyl groups are separated by 4

or more carbon atoms linearly arranged and in which at least one of said carbon atoms linearly arranged is a disubstituted carbon atom or at least 2 of said carbon atoms linearly arranged are monosubstituted carbon atoms, said liquid hydrocarbon diol existing as a liquid at a temperature of 35 ° C or less, and/or a derivative of said liquid hydrocarbon diol, and (ii) a cycloaliphatic epoxide.

2. The curable conformal coating composition of claim 1 further comprising one or more of an epoxide different from said cycloaliphatic epoxide, a polyol different from said liquid hydrocarbon diol or derivative thereof, a vinyl ester, a surfactant, a flow and leveling agent, an onium salt photoinitiator, a triflic acid salt or block Bronsted acid, and a fluorescent dye.

3. The curable conformal coating composition of claim 1 wherein the liquid hydrocarbon diol is represented by one of the formulae:

HO - R'' - OH (I)

wherein R'' is a substituted hydrocarbon residue having 8 or more carbon atoms in which the primary hydroxyl groups are separated by 4 or more carbon atoms linearly arranged and in which at least one of said carbon atoms linearly arranged is a disubstituted carbon atom or at least 2 of said carbon atoms linearly arranged are monosubstituted carbon atoms; or

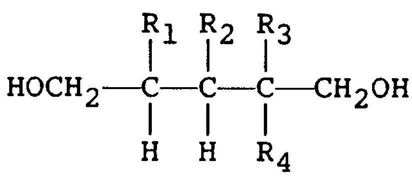

(II)

wherein $R_1$ is hydrogen or linear or branched alkyl having 1 to 3 carbon atoms, and $R_2$, $R_3$, and $R_4$ are the same or different and are hydrogen or linear or branched alkyl having 1 to 4 carbon atoms; or

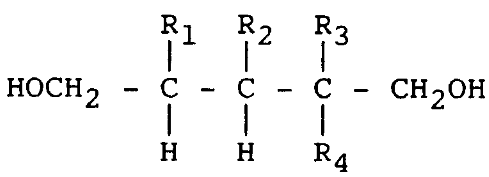

(III)

wherein $R_1$ is hydrogen or linear or branched alkyl having from 1 to 3 carbon atoms, and $R_2$, $R_3$ and R are the same or different and are hydrogen or linear or branched alkyl having from 1 to 4 carbon atoms; provided (a) at least 2 of $R_1$, $R_2$, $R_3$ and $R_4$ are other than hydrogen; (b) the total number of carbon atoms in $R_1$, $R_2$, $R_3$ and $R_4$ together is 5 or more except as follows: (i) when $R_2$ is ethyl and one of $R_1$, $R_3$ and $R_4$ is methyl, then the remaining 2 of $R_1$, $R_3$ and $R_4$ can be hydrogen; (ii) when $R_3$ and $R_4$ are independently methyl and propyl, then $R_1$ and $R_2$ can be hydrogen; and (iii) when $R_1$ is methyl and $R_2$ is ethyl and one of $R_3$ and $R_4$ is methyl, then the remaining $R_3$ or $R_4$ can be hydrogen; (c) when the total number of carbon atoms in $R_1$ and $R_2$ is 4 or more, then the total number of carbon atoms in $R_2$ is 3 or less except when $R_1$ is propyl and $R_3$ and $R_4$ are hydrogen, then $R_2$ can be butyl; and (d) when $R_1$ is ethyl and $R_2$ is propyl, then $R_3$ is other than ethyl.

4. The curable conformal coating composition of claim 1 in which the liquid hydrocarbon diol is selected from 3-ethyl-2-methyl-1,5-pentanediol, 2-ethyl-3-propyl-1,5-pentanediol, 2,4-dimethyl-3-ethyl-1,5-pentanediol, 2-ethyl-4-methyl-3-propyl-1,5-pentanediol, 2,3-diethyl-4-methyl-1,5-pentanediol, 3-ethyl-2,2,4-trimethyl-1,5-pentanediol, 2,2-dimethyl-4-ethyl-3-propyl-1,5-pentanediol, 2-methyl-2-propyl-1,5-pentanediol, 2,4-dimethyl-3-ethyl-2-propyl-1,5-pentanediol, 2,3-dipropyl-4-ethyl-2-methyl-1,5-pentanediol, 2-butyl-2-ethyl-1,5-pentanediol, 2-butyl-2,3-diethyl-4-methyl-1,5-pentanediol, 2-butyl-2,4-diethyl-3-propyl-1,5-pentanediol, 3-butyl-2-propyl-1,5-pentanediol, and mixtures thereof.

5. The curable conformal coating composition of claim 1 wherein the derivative of said liquid hydrocarbon diol is selected from polyesters, silicone-containing compounds, polyols initiated with said liquid hydrocarbon diols, and mixtures thereof.

6. The curable conformal coating composition of claim 1 wherein the cycloaliphatic epoxide has an average of one or more epoxide groups per molecule.

7. The curable conformal coating composition of claim 1 wherein the cycloaliphatic epoxide is selected from 3,4-epoxycyclohexylmethyl 3,4-epoxycyclohexanecarboxylate, diepoxides of cycloaliphatic esters of dicarboxylic acids, cycloaliphatic monoepoxides, and mixtures thereof.

8. The curable conformal coating composition of claim 2 wherein said polyol is selected from a poly(tetramethylene oxide) polyol, a polylactone polyol, a polyether polyol, a polycarbonate polyol, a poly(alkylene oxide) polyol, a polyester polyol, and mixtures thereof.

9. A cured film prepared from the curable conformal coating composition of claim 1.

10. A printed circuit board having as a conformal coating thereon, the cured product of claim 1.

European Patent Office

# EUROPEAN SEARCH REPORT

Application Number

EP 92 11 9268

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 105 488 (UNION CARBIDE CORPORATIOM)<br>* claims 1-6 *<br>--- | 1-10 | C08G59/62<br>C08G59/24<br>C09D163/00 |
| A | EP-A-0 086 102 (CELANESE CORPORATION)<br>* claim 1 *<br>----- | 1-10 | |

TECHNICAL FIELDS SEARCHED (Int. Cl.5 )

C08G
C09D

The present search report has been drawn up for all claims

| Place of search | Date of completion of the search | Examiner |
|---|---|---|
| THE HAGUE | 24 FEBRUARY 1993 | A. GLANDDIER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document